# DEMANDE DE BREVET EUROPEEN

(11) **EP 2 133 701 A1**
(43) Date de publication de la demande: **16.12.2009**
(21) Numéro de dépôt: 09354021.9
(22) Date de dépôt: 28.05.2009
(51) Int. Cl.: G01R 15/09, G01R 19/00

(54) **Dispositif de mesure de courant et unité de traitement comportant un tel dispositif**

(30) Priorité: 11.06.2008 FR 0803249
(71) Demandeur: Schneider Electric Industries SAS, 92500 Rueil-Malmaison (FR)
(72) Inventeur: Kalenine, Yvan, 38050 Grenoble Cedex 09 (FR)
(74) Mandataire: Tripodi, Paul

(57) **Abrégé**

Le dispositif de mesure de courant comporte une première résistance (1A) de mesure pour recevoir un courant (Is, IsA) de mesure, et un premier amplificateur (2A) de signal ayant une entrée connectée à la dite première résistance de mesure et une sortie pour fournir un premier signal (SA) de mesure. Une seconde résistance (1 B) de mesure est connectée en série avec ladite première résistance (1A) de mesure, et des premiers moyens de limitation (6A, 8, 9) de tension sont connectés en parallèle sur la première résistance (1A) de mesure pour dériver un premier courant de dérivation (IL1) lorsque une première tension (VL1) de limitation est atteinte sur ladite première résistance (1A) de mesure. La valeur de la première résistance (1A) de mesure est supérieure à la valeur de la seconde résistance (1B) de mesure. Une unité de traitement comporte un tel dispositif de mesure de courant.

## Description

### DOMAINE TECHNIQUE

L'invention concerne un dispositif de mesure de courant comportant :
- une résistance de mesure pour recevoir un courant de mesure d'un capteur de courant, et
- un amplificateur de signal ayant une entrée connectée à la dite résistance de mesure et une sortie pour fournir un signal de mesure représentatif d'un courant à mesurer.

### ETAT DE LA TECHNIQUE

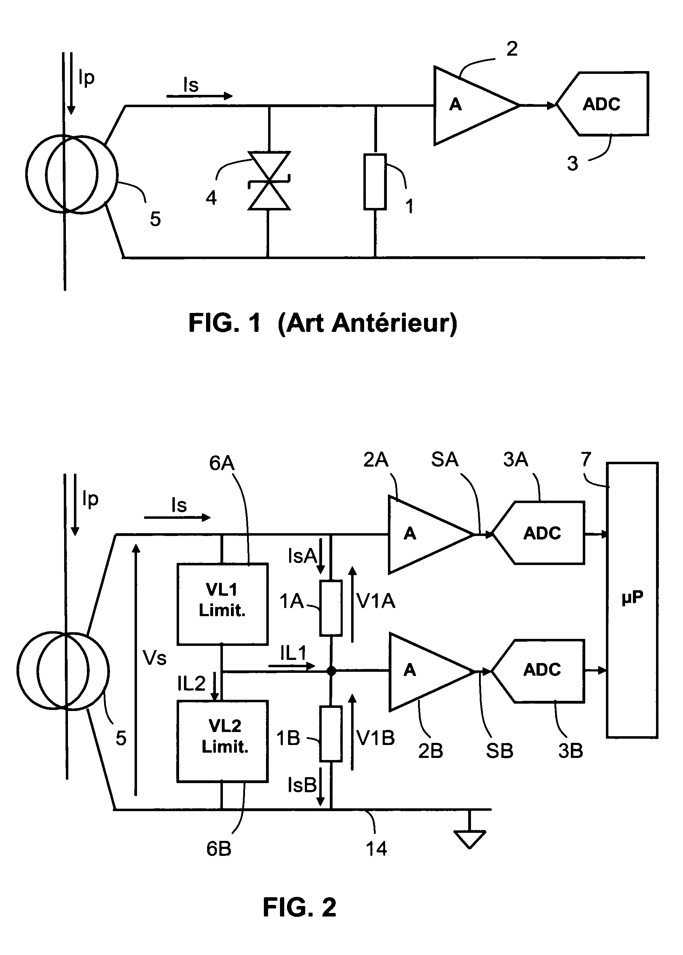

Des dispositifs de mesure de courant connus comme celui représenté sur la figure 1 comportent généralement une résistance de mesure 1 de faible valeur pour recevoir un courant à mesurer. Afin de diminuer fortement la valeur de la résistance de mesure, des dispositifs à large gamme de mesure comportent aussi un amplificateur 2 de signal connecté à la résistance de mesure pour amplifier le signal de faible valeur dû à la très basse valeur de la résistance de mesure. Un convertisseur de signal analogique-digital, connecté à une sortie de l'amplificateur, fournit un signal numérique représentatif du courant traversant la résistance de mesure. Généralement, la résistance de mesure et l'entrée de l'amplificateur sont protégées par un limiteur de surtension 4. Lorsque le dispositif de mesure est utilisé pour la mesure de forts courants alternatifs, un transformateur de courant 5 comporte un circuit primaire destiné à être traversé par un courant à mesurer et un enroulement secondaire pour fournir un courant de mesure à la résistance 1.

L'utilisation de résistances de mesure de faibles valeurs permet de ne pas perturber les circuits sur lesquels est mesuré le courant. En particulier, lorsqu'il est fait usage de transformateur de courant, une faible résistance de mesure au secondaire évite de saturer le circuit magnétique dudit transformateur.

Cependant de faibles valeurs de résistance nécessitent l'usage d'amplificateurs de signal à grand gain. Il est possible de disposer de plusieurs étages d'amplification adaptés à des niveaux de courant différents circulant dans la résistance sur la résistance 1. Des gains importants provoquent aussi une amplification du bruit et des signaux parasites particulièrement présents dans des milieux industriels. Une augmentation du gain conduit aussi à une amplification excessive de l'offset de l'amplificateur ou des autres circuits électroniques. Il existe des contrôles automatiques de gain des amplificateurs. Cependant, ces circuits complexes et peu fiables introduisent aussi des erreurs de mesure importantes.

### EXPOSE DE L'INVENTION

L'invention a pour but un dispositif de mesure de courant ayant une large plage de mesure, une faible impédance d'entrée, et une structure simple et fiable. L'invention a aussi pour objet une unité de traitement comportant un tel dispositif de mesure.

Un dispositif de mesure de courant selon l'invention comporte :
- une première résistance de mesure pour recevoir un courant de mesure,
- un premier amplificateur de signal ayant une entrée connectée à ladite première résistance de mesure et une sortie pour fournir un premier signal de mesure,
- une seconde résistance de mesure connectée en série avec ladite première résistance de mesure, et
- des premiers moyens de limitation de tension connectés en parallèle sur la première résistance de mesure pour dériver un premier courant de dérivation lorsque une première tension de limitation est atteinte sur ladite première résistance de mesure,
la valeur de la première résistance de mesure étant supérieure à la valeur de la seconde résistance de mesure.

Dans un mode de réalisation préférentiel, le dispositif se mesure comporte des seconds moyens de limitation de tension connectés en parallèle sur la seconde résistance de mesure pour dériver un second courant de limitation lorsque une seconde tension de limitation est atteinte sur ladite seconde résistance de mesure.

Dans un mode de réalisation particulier, le dispositif se mesure comporte un second amplificateur de signal connecté à la seconde résistance de mesure pour fournir un second signal de mesure, ledit premier amplificateur ayant un gain plus élevé que le gain dudit second amplificateur.

De préférence, les premiers moyens de limitation ont une tension de limitation inférieure à 1 volt pour un courant de dérivation inférieur à 1 ampère. Avantageusement, les premiers moyens de limitation comportent deux diodes connectées en tête bêche parallèle inverse.

De préférence, les seconds moyens de limitation ont une tension de limitation inférieure à 2 volts pour un courant de dérivation inférieur à 2 ampères. Avantageusement, les seconds moyens de limitation comportent deux groupes de deux diodes en série connectées en tête bêche parallèle inverse.

De préférence, un rapport entre une première chaine de gain composée de la première résistance de mesure, de la seconde résistance de mesure et de l'amplification dudit premier amplificateur sur une seconde chaine de gain composée de la seconde résistance de mesure et de l'amplification dudit second amplificateur est égale à environ la racine carrée d'une dynamique de mesure définie par une valeur maximale d'un courant à mesurer par rapport à une valeur minimale d'un courant à mesurer.

Avantageusement, un rapport entre une valeur de ladite première résistance de mesure et une valeur de ladite seconde résistance de mesure est compris entre 5 et 15.

Avantageusement, un rapport entre une amplification dudit premier amplificateur et une amplification du second amplificateur ou de la seconde chaine de gain est compris entre 5 et 20.

Une unité de traitement selon l'invention comporte :
- au moins un transformateur de courant comportant un circuit primaire pour recevoir un courant primaire à mesurer et un enroulement secondaire pour fournir un courant secondaire de mesure représentatif dudit courant primaire à mesurer,
- au moins un dispositif de mesure de courant connecté à l'enroulement secondaire dudit transformateur de courant pour mesurer ledit courant secondaire et pour fournir un signal de mesure représentatif du courant secondaire,
- des moyens de traitement connectés audit dispositif de mesure pour recevoir ledit signal de mesure,
ledit au moins un dispositif de mesure est un dispositif de mesure tel que défini ci dessus recevant le courant secondaire de mesure et fournissant :
- un premier signal de mesure représentatif d'un courant circulant dans la première résistance de mesure, et
- un second signal de mesure représentatif d'un courant circulant dans seconde résistance de mesure.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma d'un dispositif de mesure de courant de l'état de la technique,
- la figure 2 représente un premier schéma d'un dispositif de mesure de courant selon un mode de réalisation de l'invention,
- la figure 3 représente un second schéma d'un dispositif de mesure de courant selon un mode de réalisation de l'invention,
- la figure 4 représente des courbes de chaine de gain d'un dispositif de mesure de courant selon un mode de réalisation de l'invention.

### DESCRIPTION DETAILLEE DE MODES DE REALISATION PREFERES

Un dispositif de mesure de courant selon un mode de réalisation de l'invention décrit sur la figure 2 comporte une première résistance 1A de mesure pour recevoir un courant de mesure IsA, et un premier amplificateur 2A de signal ayant une entrée connectée à la dite première résistance 1A de mesure et une sortie pour fournir un premier signal de mesure SA. Avantageusement selon ce mode de réalisation de l'invention le dispositif comporte une seconde résistance de mesure 1B connectée en série avec ladite première résistance 1A, la valeur de la première résistance 1 A de mesure étant supérieure à la valeur de la seconde résistance 1B de mesure. La première résistance 1A de mesure est destinée à la mesure de courants faible alors que la résistance 1 B de très faible valeur est destinée à la mesure de courants fort. Un premier limiteur de tension 6A est connecté en parallèle sur la première résistance de mesure 1A de valeur plus élevée pour dériver un courant de dérivation IL1 vers la seconde résistance 1 B de mesure dès qu'un premier seuil de tension VL1 est dépassé.

Dans le dispositif représenté sur la figure 2, pour de très faibles courants, le courant de mesure Is passe en quasi-totalité par la première résistance 1A et par la seconde résistance 1B de valeur très faible. Ainsi, une première tension V1A est générée sur la première résistance 1 A et une seconde tension V1 B est générée sur la seconde résistance 1 B. Puisque la valeur de la résistance 1A est supérieure à la valeur de la résistance 1 B, la tension V1A est supérieure à la tension V1B. Lorsque le courant de mesure augmente, la tension V1A augmente dans les mêmes proportions. Puis, dès que le seuil VL1 du premier limiteur de tension est dépassé, un courant IL1 est dérivé de la première résistance 1A pour être appliqué directement sur la seconde résistance 1 B. Dans ce cas, le courant Is se partage entre un courant Is1 circulant dans la résistance 1 A et un courant IL1 passant par le premier limiteur de tension 6A, ces deux courants Is1 et IL1 dont la somme correspond au courant Is se retrouvent dans la seconde résistance de mesure 1B. A ce niveau de courant, la tension sur la résistance 1 A est limitée et la voie de mesure du courant est celle qui utilise la seconde résistance 1B seulement. Le retour du courant Is se fait par une ligne de référence 14.

Un tel dispositif privilégie :
- la mesure de faibles courants avec la résistance 1A de valeur moyenne ou la mise en série des résistances 1A et 1B combinée avec l'utilisation d'un amplificateur à gain moyen,
- la limitation de la tension sur la première résistance de mesure pour privilégier le passage de courant vers la seconde résistance de mesure 1B et pour limiter l'impédance d'entrée du dispositif de mesure en cas de forts courants, et
- la mesure de forts courants sur la seconde résistance de mesure 1B seulement ayant une faible valeur.

Le dispositif de la figure 2 comporte aussi un second limiteur 6B de tension connecté en parallèle sur la seconde résistance 1B de mesure afin de limiter la tension VB1 sur la seconde résistance 1 B à une seconde valeur de limitation VL2 pour de très forts courants Is pouvant aller au-delà de la plage de mesure. Ce second limiteur 6B améliore encore la faible impédance en la rendant basse pour toute valeur de courant. Ainsi, lorsque la tension VL2 sur la résistance 1B est dépassée un courant IL2 passe dans le limiteur de tension 6B. Une tension totale Vs sur les résistances 1 A et 1B en série est limitée à la somme des tensions de limitation VL1 et VL2 des limiteurs de tension 6A et 6B même pour des courants très élevés au-delà de la plage de mesure.

Avantageusement, un second amplificateur 2B de signal connecté à la seconde résistance de mesure permet de fournir un second signal de mesure amplifié, ledit premier amplificateur 2A ayant un gain plus élevé que le gain dudit second amplificateur 2B.

Les signaux de sortie SA et SB des premier et second amplificateurs 2A et 2B sont de préférence appliqués à des entrées de convertisseurs pour une conversion analogique-numérique respectivement 3A et 3B. Des signaux numériques en sortie des convertisseurs sont fournis à un circuit de traitement 7. Le circuit 7 peut être notamment un microprocesseur, un microcontrôleur ou un circuit hybride personnalisé à la demande.

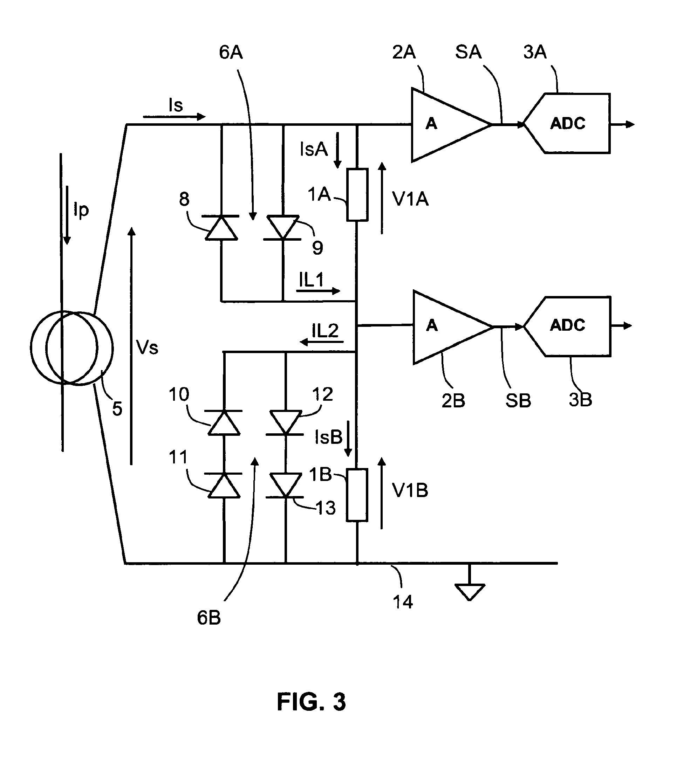

De préférence, le premier limiteur de tension a une tension de limitation inférieure à 1 volt pour un courant de dérivation inférieur à 1 ampère. Comme représenté sur la figure 3, le premier limiteur de tension comporte deux diodes 8 et 9 connectées en tête bêche parallèle inverse. Dans ce mode de réalisation, la tension de limitation correspond à une tension directe de diode. La disposition en tête bêche parallèle permet d'agir en courant alternatif de manière bidirectionnelle.

Le second limiteur de tension a de préférence une tension de limitation inférieure à 2 volts pour un courant de dérivation inférieur à 2 ampères. Dans le mode de réalisation de la figure 3, le second limiteur de tension comporte deux groupes de deux diodes 10, 11 et 12, 13 en série connectées en tête bêche parallèle inverse. La tension de limitation correspond alors à la somme de deux tensions directes de diode pouvant agir en courant alternatif de manière bidirectionnelle.

Dans le mode de réalisation des figures 2 et 3, il y a une première chaine de gain correspondant à la valeur de la première résistance à laquelle s'ajoute la valeur de la seconde résistance de mesure selon le schéma utilisé et à la valeur de l'amplification du premier amplificateur, et une seconde chaine de gain correspondant à la valeur de la seconde résistance et à la valeur du second amplificateur s'il est utilisé. Avantageusement, un rapport entre une première chaine de gain composée de la première résistance de mesure, de la seconde résistance de mesure et de l'amplification dudit premier amplificateur sur une seconde chaine de gain composée de la seconde résistance de mesure et de l'amplification dudit second amplificateur est égale à environ la racine carrée d'une dynamique de mesure définie par une valeur maximale d'un courant à mesurer par rapport à une valeur minimale d'un courant à mesurer.

Par exemple, si la valeur maximale du courant à mesurer est égale à 40 fois un courant nominal In, si la valeur minimale d'un courant à mesurer est égale à 0,1 le courant nominal et si des capteurs de courants tels que des transformateurs sont deux de types 1 ampère et 5 ampères, alors la dynamique de mesure est de (40/0.1) * (5/1) = 2000. Pour une utilisation optimale des convertisseurs, chaque convertisseur aura à traiter une dynamique égale à la racine carrée de la dynamique de mesure soit dans l'exemple environ 45. Le rapport entre les chaines de gain peut être reparti entre le rapport des amplitudes des amplificateurs et le rapport entre les résistances ou les groupes de résistances (1A + 1B) sur la valeur de la résistance la plus faible 1B. Dans le cas où la seconde chaine de gain, formée par la résistance 1B avec un second amplificateur 2B de gain 1 ou sans amplificateur, a un gain de 1, la première chaine, formée par les résistances 1A et 1B et par l'amplificateur 2A, a un gain de 45. Ce gain de 45 est avantageusement réparti entre les valeurs des résistances 1A et 1B et l'amplification de l'amplificateur 2A. Dans cet exemple, si la résistance de référence 1B a 1 ohm, la résistance 1A peut avoir 6,5 ohms et l'amplification du premier amplificateur peut être de 6.

La première chaine a un gain de ((1 + 6,5) * 6) = 45, et permet au convertisseur de traiter avec précision les signaux faibles de niveau relatif 1 à 45 avec une dynamique utile de 45.
La seconde chaine de gain est de (1 * 1) = 1, et permet au convertisseur de traiter les signaux forts de niveau relatif 45 à 2000 avec une dynamique utile de 45.

Dans ces modes de réalisation de l'invention, le rapport entre une valeur de ladite première résistance de mesure 1B et une valeur de ladite seconde résistance de mesure 1A est compris entre 5 et 15. Avantageusement, le rapport entre une amplification du premier amplificateur 2A et une amplification de la seconde chaine d'amplification est compris entre 5 et 20. La seconde chaine d'amplification peut avoir un amplificateur, mais avec un gain de 1 elle peut être dispensée d'amplificateur.

Dans les modes de réalisation des figures 2 et 3, les références des chaines de gain peuvent être considérées en partant de la somme des deux résistances 1A et 1B. Dans ce cas, la première chaine de gain correspond à l'amplification par le premier amplificateur et la seconde chaine de gain correspond à l'atténuation provoquée par le diviseur résistif constitué par les résistances 1A et 1B connectées en série et dont le point commun du milieu et la sortie pour le second signal à appliqué à un second amplificateur 2B éventuel. Dans un exemple identique à celui cité plus haut, la première chaine de gain a la valeur de l'amplification 6 et la seconde chaine de gain est une atténuation du pont diviseur soit (1B / 1A +1B) = (1/(1+6,5)) = 1/7,5, le rapport entre les deux chaines de gain et aussi 6/(1/7,5) = 45.

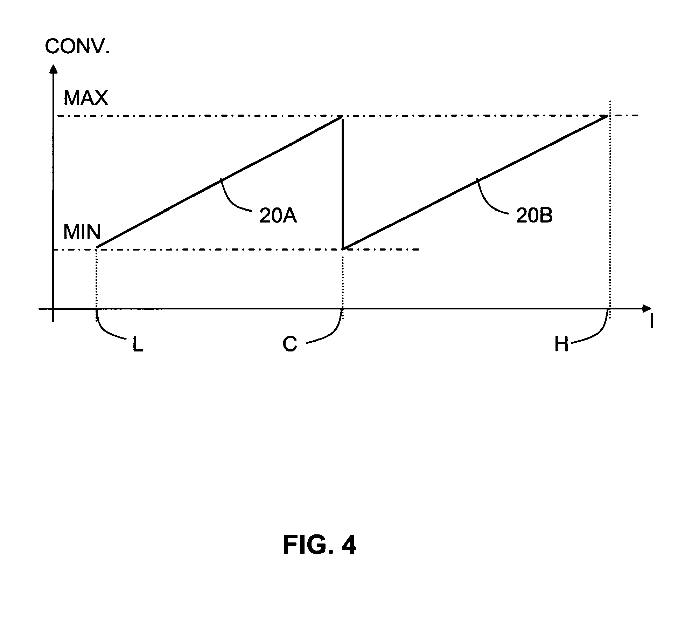

La figure 4 montre des courbes de chaines de gain d'un dispositif de mesure de courant selon un mode de réalisation de l'invention. Cette figure montre les fenêtres de conversion CONV des convertisseurs 3A et 3B entre un nombre de points minimum de conversion MIN et un maximum de points de conversion MAX correspondant au signal maximal d'entrée du convertisseur. Dans ces fenêtres de conversion, une première chaine de gain 20A a un gain élevé et fonctionne entre une limite minimum L de courant à mesurer et un point de commutation C, et une seconde chaine de gain 20B a un gain faible ou une atténuation et fonctionne entre le point de commutation C et une limite maximale H de courant à mesurer.

Un dispositif de mesure tel que décrit ci-dessus est particulièrement adapté aux unités de traitement pour le contrôle ou la protection des appareils de coupure électriques. Dans ce cas, l'unité de traitement comporte au moins un transformateur de courant 5 comportant un circuit primaire pour recevoir un courant primaire Ip à mesurer et un enroulement secondaire pour fournir un courant secondaire Is de mesure représentatif dudit courant primaire à mesurer. Un dispositif de mesure de courant est connecté à l'enroulement secondaire dudit transformateur de courant pour mesurer ledit courant secondaire et pour fournir un signal de mesure représentatif dudit courant secondaire Is. Un circuit de traitement est connecté audit dispositif de mesure pour reçoit ledit signal de mesure et traite des fonctions de contrôle et de protection. Les convertisseurs de signaux 3A et 3B pour une conversion analogique-numérique peuvent intégrés au circuit de traitement 7.

Pour des appareils à haute ou moyenne tension et/ou à fort courant le transformateur de courant peut être une chaine de deux ou trois transformateurs courant. Les courants à mesurer peuvent être des courants polaires de phase ou de neutre ou des courants homopolaire par exemple de défaut à la terre. Dans ce cas, les plages de mesure peuvent être différentes.

Les dispositifs selon l'invention peuvent fonctionner avec des courants de mesure Is très différents pouvant être par exemple de quelques milliampères à plusieurs ampères en courants alternatifs ou continus.

Dans les modes de réalisation décrits ci-dessus, les résistances de mesure en série sont disposées de manière à ce que la seconde résistance de faible valeur 1B soit connectée à la ligne de référence 14. Bien entendu, l'ordre des résistances peut être inversé par rapport à la ligne de référence. Les deux résistances peuvent aussi être indépendantes en utilisant notamment des amplificateurs différentiels pour l'amplification des signaux.

## Revendications

1. Dispositif de mesure de courant **caractérisé en ce qu'**il comporte:
- une première résistance (1A) de mesure pour recevoir un courant (Is, IsA) de mesure,
- un premier amplificateur (2A) de signal ayant une entrée connectée à ladite première résistance de mesure et une sortie pour fournir un premier signal (SA) de mesure,
- une seconde résistance (1 B) de mesure connectée en série avec ladite première résistance (1A) de mesure, et
- des premiers moyens de limitation (6A, 8, 9) de tension connectés en parallèle sur la première résistance (1A) de mesure pour dériver un premier courant de dérivation (IL1) lorsque une première tension (VL1) de limitation est atteinte sur ladite première résistance (1A) de mesure,
la valeur de la première résistance (1A) de mesure étant supérieure à la valeur de la seconde résistance (1 B) de mesure.

2. Dispositif de mesure selon la revendication 1 **caractérisé en ce qu'**il comporte des seconds moyens de limitation (6B, 10-13) de tension connectés en parallèle sur la seconde résistance (1B) de mesure pour dériver un second courant de limitation (IL2) lorsque une seconde tension (VL2) de limitation est atteinte sur ladite seconde résistance (1 B) de mesure.

3. Dispositif de mesure selon l'une des revendications 1 ou 2 **caractérisé en ce qu'**il comporte un second amplificateur (2B) de signal connecté à la seconde résistance (1B) de mesure pour fournir un second signal (SB) de mesure , ledit premier amplificateur (2A) ayant un gain plus élevé que le gain dudit second amplificateur (2B).

4. Dispositif de mesure selon l'une quelconque des revendications 1 à 3 **caractérisé en ce que** les premiers moyens de limitation (6A, 8, 9) ont une tension de limitation (VL1) inférieure à 1 volt pour un courant de dérivation (IL1) inférieur à 1 ampère.

5. Dispositif de mesure selon la revendication 4 **caractérisé en ce que** les premiers moyens de limitation (6A) comportent deux diodes (8, 9) connectées en tête bêche parallèle inverse.

6. Dispositif de mesure selon l'une quelconque des revendications 1 à 5 **caractérisé en ce que** les seconds moyens de limitation (6B) ont une tension de limitation (VL2) inférieure à 2 volts pour un courant de dérivation (IL2) inférieur à 2 ampères.

7. Dispositif de mesure selon la revendication 6 **caractérisé en ce que** les seconds moyens de limitation (6B) comportent deux groupes de deux diodes en série (10-13) connectées en tête bêche parallèle inverse.

8. Dispositif de mesure selon l'une quelconque des revendications 1 à 7 **caractérisé en ce qu'**un rapport entre une première chaine de gain composée de la première résistance (1A) de mesure, de la seconde résistance (1B) de mesure et de l'amplification dudit premier amplificateur (2A) sur une seconde chaine de gain composée de la seconde résistance (1B) de mesure et de l'amplification dudit second amplificateur (2B) est égale à environ la racine carrée d'une dynamique de mesure définie par une valeur maximale (M) d'un courant à mesurer par rapport à une valeur minimale (L) d'un courant à mesurer.

9. Dispositif de mesure selon l'une quelconque des revendications 1 à 8 **caractérisé en ce qu'**un rapport entre une valeur de ladite première résistance (1A) de mesure et une valeur de ladite seconde résistance (1B) de mesure est compris entre 5 et 15.

10. Dispositif de mesure selon l'une quelconque des revendications 1 à 9 **caractérisé en ce qu'**un rapport entre une amplification dudit premier amplificateur (2A) et une amplification du second amplificateur (2B) ou de la seconde chaine de gain est compris entre 5 et 20.

11. Unité de traitement comportant :
- au moins un transformateur (5) de courant comportant un circuit primaire pour recevoir un courant primaire (1p) à mesurer et un enroulement secondaire pour fournir un courant secondaire (1s) de mesure représentatif dudit courant primaire à mesurer,
- au moins un dispositif de mesure de courant connecté à l'enroulement secondaire dudit transformateur de courant pour mesurer ledit courant secondaire (Is) et pour fournir un signal de mesure représentatif du courant secondaire,
- des moyens de traitement (7) connectés audit dispositif de mesure pour recevoir ledit signal de mesure,
**caractérisé en ce que** ledit au moins un dispositif de mesure est un dispositif de mesure selon l'une quelconque des revendications 1 à 10 recevant le courant secondaire (Is) de mesure et fournissant :
- un premier signal (SA) de mesure représentatif d'un courant circulant dans la première résistance (1A) de mesure, et
- un second signal (SB) de mesure représentatif d'un courant circulant dans seconde résistance (1B) de mesure.
